## Europäisches Patentamt

## European Patent Office

## Office européen des brevets

(19)

(11) Numéro de publication: **0 090 753 B1**

(12) # FASCICULE DE BREVET EUROPEEN

(45) Date de publication du fascicule du brevet:
28.01.87

(51) Int. Cl.⁴: **H 05 K 13/04,** H 05 K 13/02

(21) Numéro de dépôt: **83430011.3**

(22) Date de dépôt: **25.03.83**

(54) **Machine pour insérer automatiquement des composants électroniques, notamment des circuits intégrés, sur des circuits imprimés.**

(30) Priorité: **26.03.82 FR 8205362**

(43) Date de publication de la demande:
**05.10.83 Bulletin 83/40**

(45) Mention de la délivrance du brevet:
**28.01.87 Bulletin 87/5**

(84) Etats contractants désignés:
**AT BE CH DE GB IT LI NL SE**

(56) Documents cités:
**DE - A - 2 625 738
DE - A - 2 844 169
US - A - 3 570 099
US - A - 4 000 798
US - A - 4 045 870**

(73) Titulaire: **OUTILLAGES SCIENTIFIQUES ET DE LABORATOIRES - O.S.L. Société Anonyme dite:, Zone Industrielle Lot R., F-06510 Carros Industries (FR)**

(72) Inventeur: **Benni, André, 5, Boulevard de la Madeleine, F-06000 Nice (FR)**

(74) Mandataire: **Azais, Henri et al, c/o CABINET BEAU DE LOMENIE 14, rue Raphael, F-13008 Marseille (FR)**

ACTORUM AG

## Description

La présente invention a pour objet des machines destinées à insérer automatiquement des composants électroniques, notamment des circuits intégrés, sur des cartes de circuits imprimés.

Le secteur technique de l'invention est celui de la construction de machines-transfert ou robots ou automates destinés à l'équipement en série de cartes de circuits imprimés.

Les appareils électroniques qui sont fabriqués en série comportent des cartes de circuits imprimés sur lesquelles des composants électroniques doivent être insérés dans des positions bien déterminées. La construction de circuits électroniques fait appel de plus en plus à des plaquettes ou puces de circuits hautement intégrés (L.S.I.), qui remplissent diverses fonctions telles qu'unité de calcul et de mémoire entrant dans la composition de microprocesseurs ou d'autres fonctions telles que compteurs d'impulsions, diviseurs de fréquences, codeurs ou décodeurs, convertisseurs binaires à décimal.

Les circuits intégrés se présentent sous la forme de plaquettes rectangulaires comportant le long de chacun de leurs deux côtés longitudinaux une série de pattes conductrices qui pénètrent chacune dans un petit trou de la carte de circuit imprimé pour établir les liaisons électriques entre le circuit intégré et les circuits imprimés au recto de la carte, c'est-à-dire du côté opposé à celui qui porte les composants que l'on désignera ci-après par le verso.

Pour abaisser le coût de confection des cartes de circuits imprimés, qui sont fabriquées en séries comportant de nombreuses cartes identiques, il est intéressant de mettre au point des machines transfert capables de prélever successivement et automatiquement des plaquettes de circuits intégrés dans des magasins contenant plusieurs types de plaquettes et d'amener automatiquement ces plaquettes et les cartes de circuit imprimé dans des positions relatives telles que les pattes de chaque plaquette se situent exactement en face des trous percés dans la carte pour les recevoir, puis d'insérer les pattes dans ces trous et enfin de sectionner la partie des pattes qui dépasse au recto de la carte.

Le brevet DE-A-2 625 738 (TELEFONBAU und NORMALZEIT GmbH) décrit une machine pour insérer automatiquement des plaquettes de circuits intégrés dans des cartes électroniques de circuits imprimés qui comporte:

– une table horizontale fixe sur laquelle les cartes sont posées,

– un dispositif de transfert qui est constitué par un tiroir coulissant horizontalement disposé au-dessus de ladite table,

– un magasin comportant une rangée de barreaux verticaux dans lesquels les plaquettes de circuits intégrés sont disposées,

– une rampe inclinée,

– et une pince d'insertion des plaquettes qui est située au-dessus de ladite table et qui est portée par un support déplaçable verticalement.

Le but de la présente invention est de procurer une machine-transfert perfectionnée capable d'insérer automatiquement, avec une très grande précision, plusieurs plaquettes de circuits imprimés sur une même carte, avec des possibilités de choix entre un grand nombre de types de plaquettes et avec une cadence d'insertion plus élevée que dans les machines connues de ce type du fait que plusieurs opérations sont effectuées simultanément grâce à l'organisation générale de la machine.

Le but de l'invention est atteint au moyen d'une machine qui comporte en combinaison:

– une table horizontale déplaçable suivant deux axes perpendiculaires sur laquelle lesdites cartes sont posées;

– un dispositif de transfert rotatif qui est disposé au-dessus de ladite table et qui est entraîné en rotation, pas à pas, autour d'un axe de rotation vertical, lequel dispositif de transfert comporte plusieurs bras radiaux qui sont articulés chacun autour d'un axe horizontal;

– au moins une rampe inclinée en descendant vers un point situé sur ledit axe de rotation;

– au moins une rangée de magasins verticaux situés au-dessus de chaque rampe, chaque magasin recevant un étui dans lequel lesdites plaquettes sont livrées;

– et une pince d'insertion desdites plaquettes qui est située au-dessus de ladite table et qui est portée par un support qui est déplaçable à la fois le long de son axe vertical et horizontalement dans le plan passant par ledit axe vertical du support et par ledit axe de rotation vertical.

Le dispositif de transfert rotatif comporte des moyens pour maintenir les bras radiaux inclinés parallèlement aux rampes lorsqu'ils sont placés dans l'alignement de celles-ci et pour amener en position horizontale le bras qui se trouve dans le plan passant par l'axe de rotation vertical du dispositif de transfert et par l'axe vertical du support de la pince d'insertion.

Une machine selon l'invention comporte avantageusement un dispositif photo-électrique d'autocentrage des cartes de circuit imprimé par rapport à l'axe de la pince d'insertion, qui comporte un émetteur lumineux qui est situé au-dessus de ladite table mobile et qui émet deux faisceaux lumineux parallèles audit axe et symétriques par rapport à celui-ci et il comporte, en outre, deux récepteurs photo-électriques qui sont situés au-dessous de ladite table dans l'alignement desdits faisceaux, chacun de ces récepteurs étant composé de deux demi-fibres optiques symétriques par rapport à un plan diamétral et de deux photo-transistors situés en regard de l'extrémité de chacune desdites demi-fibres, lesquels photo-transistors sont placés dans un montage différentiel qui commande automatiquement le servomoteur qui déplace ladite table horizontale dans le sens qui annule la différence entre les deux signaux.

L'invention a pour résultat une nouvelle machine-transfert permettant d'insérer automatiquement des composants électroniques, notamment des plaquettes de circuits intégrés, sur des cartes de circuits imprimés.

Un avantage d'une machine selon l'invention réside dans le fait que, grâce au dispositif de transfert rotatif, on peut disposer en étoile autour de celui-ci plusieurs rangées de magasins contenant des circuits intégrés différents, correspondant à un grand nombre de types de circuits intégrés.

Un autre avantage d'une machine selon l'invention est que, grâce au double mouvement vertical et horizontal de la pince d'insertion, plusieurs opérations peuvent avoir lieu simultanément.

En même temps que la pince d'insertion saisit une plaquette sur l'un des bras radiaux, une autre plaquette se met en place sur une autre bras du transfert. De même, pendant que la pince d'insertion effectue son mouvement vertical pour insérer une plaquette dans une carte, le transfert rotatif tourne pour positionner les bras radiaux pour le cycle suivant. Cette simultanéité de plusieurs opérations permet d'obtenir une cadence élevée.

Un autre avantage des machines selon l'invention réside dans le dispositif d'auto-centrage photo-électrique composé de demi-fibres optiques qui permet d'obtenir un très bon positionnement des cartes à la fois au moment de la programmation manuelle d'une série de fabrications et chaque fois que la carte est déplacée pour recevoir une nouvelle plaquette en cours de fabrication.

La description suivante se réfère aux dessins annexés qui représentent, sans aucun caractère limitatif, un exemple de réalisation d'une machine-transfert selon l'invention.

La figure 1 est une vue de face en élévation de la machine.

La figure 2 est une vue de côté de la machine selon II–II de la figure 1.

La figure 3 est une coupe axiale du dispositif de transfert rotatif.

La figure 4 est une vue suivant IV–IV de la figure 3.

Les figures 5 et 6 sont des vues à plus grande échelle respectivement en élévation et de dessus d'un bras radial du dispositif de transfert rotatif.

La figure 7 est une vue en élévation schématique du dispositif d'auto-centrage.

La figure 8 est une coupe selon VIII–VIII de la figure 7.

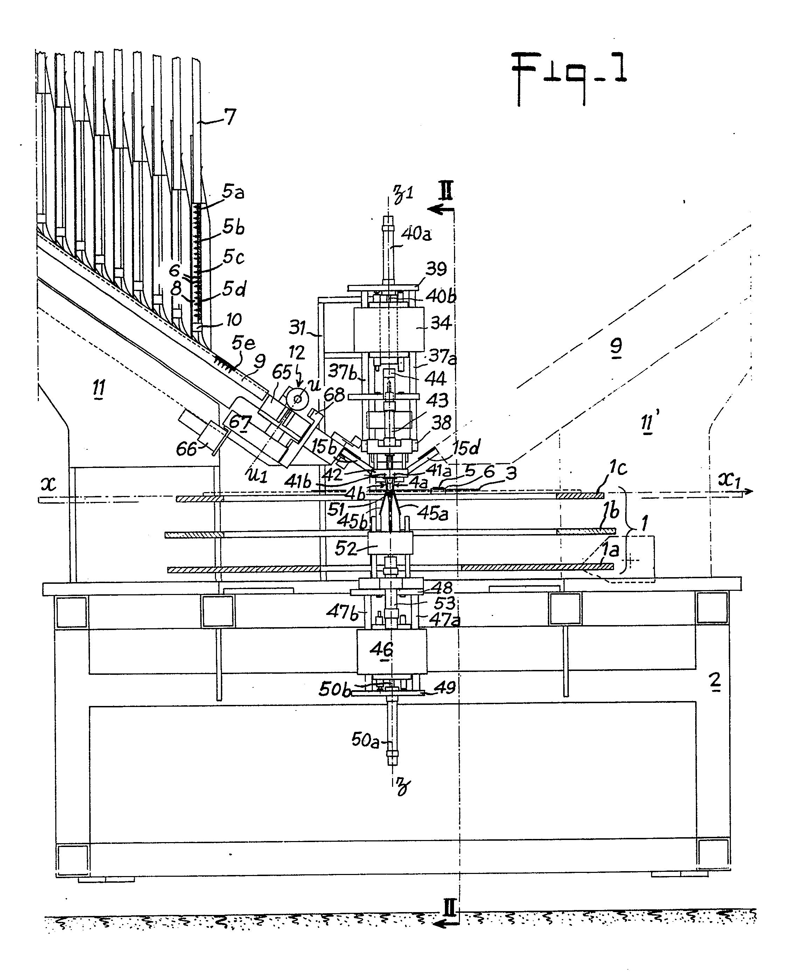

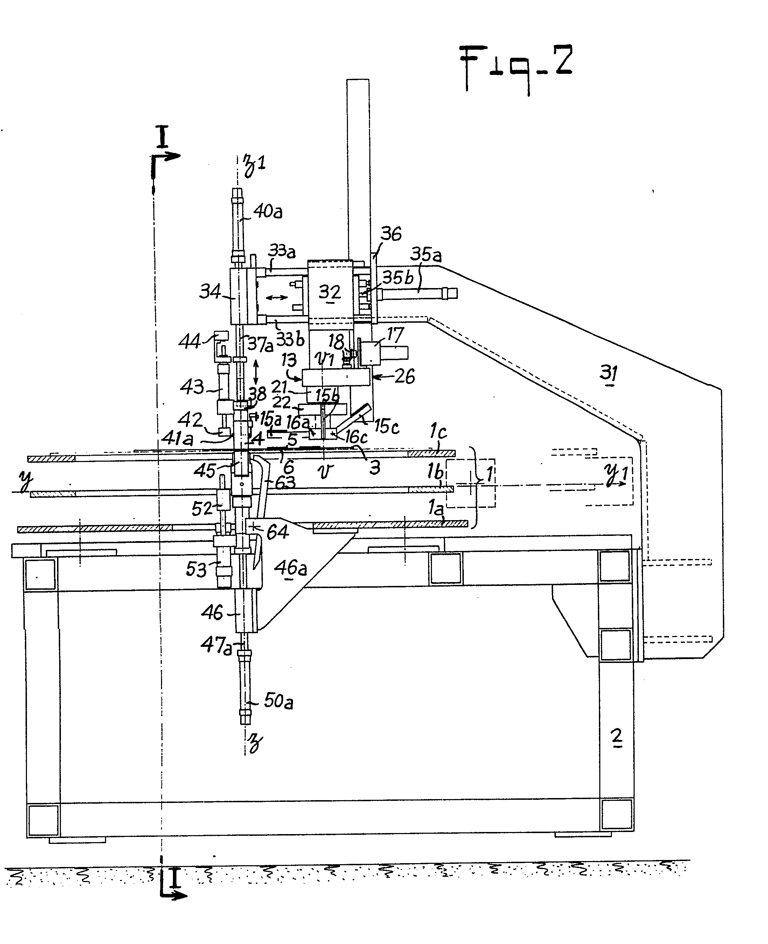

Les figures 1 et 2 représentent une vue d'ensemble d'une machine-transfert, qui a pour fonction d'insérer automatiquement des plaquettes de circuits intégrés, choisies parmi plusieurs types de circuits, dans des cartes de circuits imprimés, en des positions parfaitement déterminées.

La machine comporte une table de travail 1, qui est montée sur un bâti 2. La table de travail comporte une table horizontale de base fixe 1a, une deuxième table horizontale 1b qui est déplaçable suivant un axe y y1, contenu dans le plan de la figure 2, et une troisième table 1c qui est déplaçable par rapport à la table 1b, suivant un axe x x1, contenu dans le plan de la figure 1 et perpendiculaire à l'axe y y1.

Les déplacements horizontaux des tables sont commandés par des servomoteurs ou par des servomécanismes. De telles tables mobiles suivant deux axes perpendiculaires sont connues et il n'est pas nécessaire de les décrire en détail.

Les cartes de circuit imprimé 3 sont posées sur la table supérieure 1c, la face recto qui porte les circuits imprimés étant dirigée vers le bas et le verso, qui doit recevoir les composants, étant dirigé vers le haut. Les cartes comportent des rangées de petits trous qui traversent la carte et qui sont situés aux emplacements du circuit destinés à recevoir certains composants. Les pattes d'une plaquette de circuit intégré doivent être engagées simultanément dans tous les trous destinés à les recevoir et il est donc nécessaire que la carte soit positionnée parfaitement par rapport aux pinces qui vont amener la plaquette au-dessus de la carte et qui vont faire descendre celle-ci pour engager les pattes dans les trous.

Au départ d'une opération d'équipement d'une carte 3, celle-ci est positionnée avec une très grande précision sur la table 1c. Après quoi, suivant un programme enregistré, les servomoteurs vont déplacer la table 1c suivant les axes x x1 et y y1 pour amener successivement les divers emplacements destinés à recevoir un circuit intégré dans l'alignement d'un axe vertical z z1, le long duquel se déplace la pince 4, qui saisit les circuits intégrés 5 et qui se déplace verticalement vers le bas pour insérer les pattes 6 d'un circuit intégré 5 à travers les trous d'une carte 3.

On a représenté sur les figures 1 et 2 une carte 3 posée sur la table 1c et portant au verso des plaquettes de circuits intégrés 5 dont les pattes 6 sont engagées à travers la carte.

Les plaquettes de circuits intégrés 5 sont livrées dans des étuis rectangulaires 7, dans lesquels elles sont juxtaposées par leurs petits côtés. Les étuis 7 sont placés au-dessus de magasins verticaux 8 dans lesquels les plaquettes 5 descendent par gravité. On a représenté un magasin 8 contenant quatre circuits intégrés 5a, 5b, 5c, 5d dont les pattes 6 sont engagées dans des rainures verticales.

Chaque étui 7 et chaque magasin 8 peut contenir des circuits intégrés d'une variété déterminée, de sorte que la machine selon l'invention peut équiper des cartes avec autant de variétés de circuits intégrés qu'elle comporte de magasins.

Les magasins sont réunis selon une ou plusieurs rangées, chaque rangée étant desservie par une rampe inclinée 9 qui passe sous les extrémités inférieures de tous les magasins d'une rangée et qui reçoit les plaquettes tombant des différents magasins. L'extrémité inférieure de chaque magasin comporte un verrou électromagnétique 10 qui est commandé par l'unité centrale de la machine-transfert pour libérer une des plaquettes correspondant à la variété qui doit être placée sur la carte 3. La figure 1 représente une plaquette 5e en train de descendre par gravité le long de la rampe 9.

La rampe 9 est posée sur un support incliné 11 porté par le bâti de la machine.

Une machine selon l'invention peut comporter plusieurs bâtis 11 disposés en étoile autour d'un axe v v1 et chacun de ces bâtis peut porter une rampe 9 surmontée d'un groupe de magasins 8.

Les différentes rampes 9 convergent en descendant vers un même sommet situé sur l'axe v v1.

Par exemple, la figure 1 représente une machine qui comporte deux supports 11 et 11′ et deux rampes 9 et 9′, situées dans le plan de la figure, symétriquement par rapport à un plan passant par l'axe v v1.

Chaque rampe 9 comporte un dispositif d'inversion de polarité 12 qui permet de faire pivoter une plaquette de 180° autour d'un axe u u1 perpendiculaire au plan de la plaquette. Ce dispositif 12 sera décrit en détail plus loin.

Une machine selon l'invention comporte un dispositif de transfert rotatif 13 qui est disposé au-dessus de la table de travail, qui comporte un croisillon 14 qui est monté pivotant autour d'un axe vertical v v1 et qui porte des bras 15 disposés en étoile 15a, 15b, 15c.

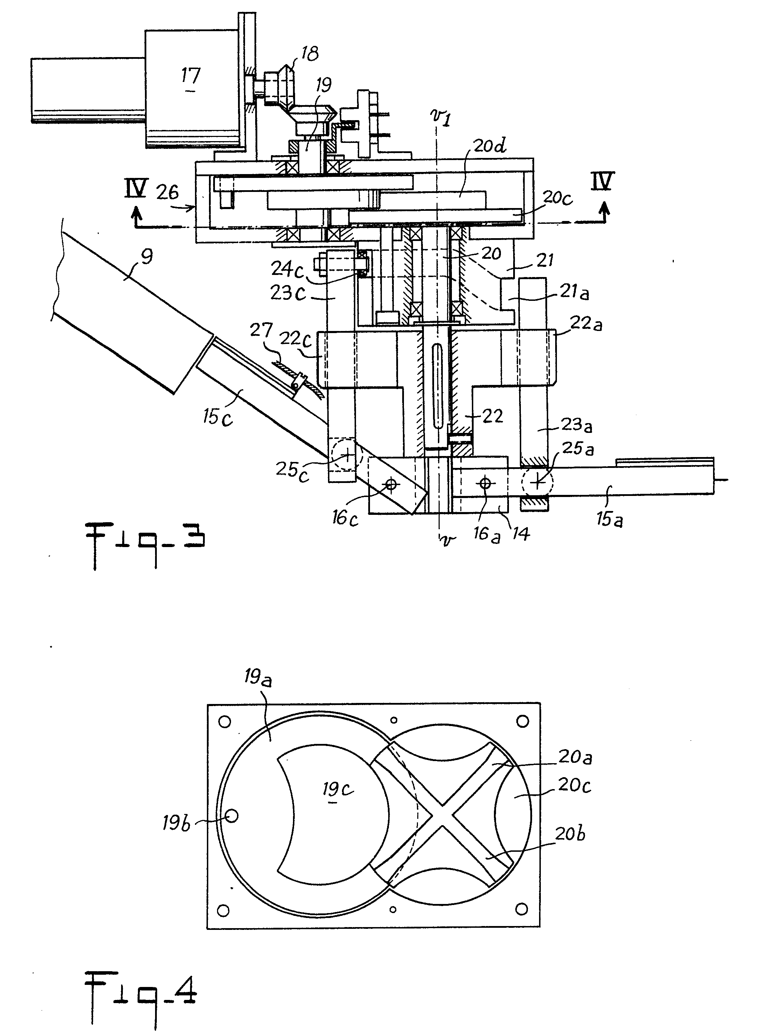

La figure 3 est une coupe verticale axiale à plus grande échelle du transfert rotatif des figures 1 et 2 qui correspond à un mode de réalisation dans lequel le croisillon 14 porte quatre bras radiaux ou doigts 15a, 15b, 15c, 15d disposés en croix. Chacun de ces bras est articulé autour d'un axe horizontal 16a, 16b, 16c, 16d de telle sorte qu'il peut passer d'une position inclinée 15b, 15c, 15d dans laquelle il vient se placer dans l'alignement d'une rampe 9 comme on le voit sur les figures 1 à 3 à une position horizontale 15a dans laquelle il se trouve dans le plan vertical P défini par les axes z z1 et v v1, qui est le plan dans lequel se déplace horizontalement le support de la pince 4 comme on l'expliquera ci-après. Le plan P est le plan de la figure 2.

On voit sur la figure 3 le dispositif d'entraînement pas à pas du transfert rotatif 13. Ce dispositif comporte un groupe moto-réducteur qui effectue un tour complet chaque fois que le moteur est mis en route, un contact de fin de course l'arrêtant automatiquement à la fin de chaque tour. Le groupe motoréducteur 17 entraîne par un engrenage à pignons coniques 18 un arbre 19 qui entraîne un arbre de sortie 20 d'axe v v1 par l'intermédiaire d'un dispositif de transmission indexeur 26 du type dit à croix de Saint André ou à croix de Malte ou à croix de Genève, représenté sur la figure 4. Ce dispositif est suffisamment connu des mécaniciens pour qu'il ne soit pas nécessaire de le décrire en détail.

L'arbre 19 porte un disque 19a portant un ergot 19b qui engrène avec l'une des deux rainures en croix 20a, 20b découpées dans un disque 20c monté sur l'arbre de sortie 20. Le disque 19a porte un disque tronqué 19c et le disque 20c porte un disque 20d comportant quatre troncatures en croix qui coopèrent avec le disque 19c sur les trois quarts d'un tour de celui-ci. On rappelle que ce dispositif permet de faire tourner l'arbre 20 d'un quart de tour pour un tour complet de l'arbre 19. Autour de l'arbre 20 est disposée une bague fixe ou cloche 21 qui porte à sa périphérie une rainure

21a en forme de came hélicoïdale ayant un point bas situé dans le plan défini par les axes v v1 et z z1. Sur l'arbre 20 est clavetée une pièce 22 comportant quatre bras en croix 22a, 22b, 22c, 22d. Chacun de ces bras comporte une entaille verticale dans laquelle est logé un poussoir vertical 23a, 23b, 23c, 23d. Chacun de ces poussoirs comporte, à l'extrémité supérieure, un galet 24a, 24b, 24c, 24d qui est monté sur un axe horizontal et qui est engagé dans la rainure hélicoïdale 21a. Chacun des poussoirs comporte, en outre, au voisinage de l'extrémité inférieure, une articulation 25a, 25b, 25c, 25d sur l'un des bras 15a, 15b, 15c, 15d.

Le fonctionnement du transfert rotatif 13 est le suivant.

Les bras 15a, 15b, 15c, 15d, le croisillon 14, la pièce 22 et les quatre poussoirs 23a, 23b, 23c, 23d sont entraînés en rotation par l'arbre 20 par pas égaux à un quart de tour. La partie haute de la rainure hélicoïdale 21a s'étend sur les trois quarts de la périphérie de la bague 21 et la partie basse se situe dans le plan défini par les axes v v1 et z z1. Pendant trois pas d'avancement de l'arbre 20, le galet 24 équipant l'un des poussoirs se trouve dans la partie haute de la rainure 21a, et le poussoir correspondant maintient le bras 15 en position inclinée parallèle à une rampe 9. Quand le bras 15 arrive dans le plan défini par les axes v v1 et z z1, le galet 24 descend dans la partie basse de la rainure 21a et le poussoir 23 coulisse vers le bas et fait pivoter le bras 15 autour de l'articulation 16 pour l'amener dans la position horizontale représentée sur la partie droite de la figure 3, qui est la position de présentation d'une plaquette sous les pinces 4 qui se déplacent dans le plan défini par les axes v v1, z z1 qui est le plan de la figure 2.

Le mode de réalisation qui vient d'être décrit comporte un dispositif de transfert rotatif 13 équipé de quatre bras disposés en croix. Il est précisé que le transfert 13 pourrait comporter un nombre différent de bras disposés en étoile autour de l'axe v v1 et que le dispositif 26 de transmission du mouvement 20 composé d'une croix de Saint André serait remplacé par un autre dispositif de transmission permettant de faire tourner pas à pas l'arbre 20, de telle sorte qu'il avance à chaque pas d'un angle égal à l'écart angulaire entre deux bras successifs.

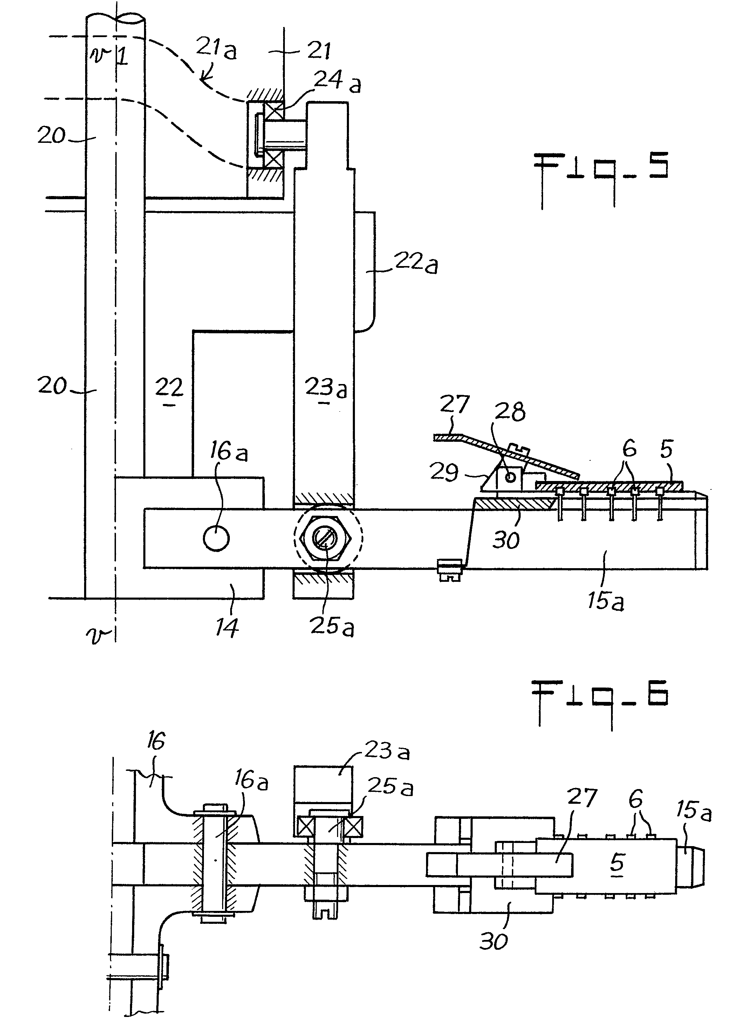

Les figures 5 et 6 représentent respectivement une coupe verticale partielle et une vue de dessus de l'un des bras dans la position horizontale 15a. Chaque bras 15 est équipé d'une pince 27 qui est montée pivotante autour d'un axe 28 et qui est équipée d'un ressort de rappel 29.

On a représenté sur les figures 5 et 6 une plaquette 5 de circuit imprimé équipée de deux rangées de pattes. Chaque bras comporte, en outre, une butée 30 en forme de fourche à deux bras et les parties minces des deux premières pattes de chaque plaquette viennent s'appuyer contre les extrémités de ces deux bras.

La butée 30 assure un positionnement bien déterminé des pattes de la plaquette sur le bras distributeur. La pince 27 s'appuie sur la plaquette pour la maintenir en place pendant le mouvement de rotation du bras. Lorsque le bras est dans l'une des positions inclinées 15b, 15c, 15d, en face de l'extrémité des rampes 9, l'extrémité de la pince 27 située du côté de l'axe vient s'appuyer contre le bord du bras 22b, 22c ou 22d, ce qui la maintient relevée.

On a représenté, sur la partie gauche de la figure 3, un bras 15c portant une pince 27 en position relevée, prête à recevoir une plaquette provenant de la rampe 9.

Revenant aux figures 1 et 2, celles-ci représentent la pince 4 destinée à saisir les plaquettes 5 sur le bras 15a pour les amener au-dessus d'une carte 3 et pour les insérer dans celle-ci.

Selon une caractéristique d'une machine-transfert selon l'invention, la pince 4 est déplaçable à la fois en translation horizontale dans le plan de la figure 2 et verticalement le long de l'axe z z1.

La pince 4 est portée par un support qui est supporté par une potence 31 fixée au bâti.

Le mécanisme de déplacement horizontal de la pince 4 comporte un bâti fixe 32 fixé à la potence 31. Ce bâti 32 comporte des douilles à bille dans lesquelles coulissent des tiges horizontales 33a, 33b, qui supportent un bâti mobile 34.

Le mécanisme de déplacement horizontal comporte un vérin dont le cylindre mobile 35a est fixé à une plaque 36 fixée aux extrémités des tiges 33 opposées au bâti 34. La tige 35b du vérin prend appui sur le bâti fixe 32, de sorte que le mouvement du cylindre du vérin déplace horizontalement les tiges 33 et le bâti 34 sur une course qui est déterminée avec précision par des butées et qui amène la pince 4 alternativement au-dessus du bras 15a, pour saisir la plaquette posée sur ce bras, puis en avant de ce bras dans l'alignement d'un axe vertical fixe z z1.

Le mouvement horizontal de la pince 4 présente des avantages. D'une part, il permet de dégager la pince à une certaine distance de l'axe v v1 et, donc, d'équiper l'appareil d'un distributeur rotatif 13, pivotant autour de l'axe v v1, qui peut desservir plusieurs magasins disposés en étoile autour de cet axe, d'où la possibilité de stocker et de distribuer un grand nombre de modèles de plaquettes différentes.

D'autre part, lorsque la pince 4 se trouve au-dessus du bras 15a, l'espace situé dans l'alignement de l'axe vertical z z1 se trouve dégagé, ce qui permet de disposer au-dessus du mécanisme de déplacement de la pince un dispositif optique d'auto-centrage des cartes de circuit imprimé qui amène automatiquement les deux premiers trous de la carte destinés à recevoir les deux premières pattes d'une plaquette dans une position parfaitement déterminée par rapport à l'axe z z1, pendant que la pince va chercher la plaquette sur le bras distributeur 15a.

On voit sur la figure 1 le mécanisme de déplacement vertical de la pince 4 qui est analogue au mécanisme de déplacement horizontal. Le bâti 34, mobile horizontalement, comporte des douilles à bille dans lesquelles coulissent des tiges 37a, 37b dont les extrémités inférieures portent un support 38 de la pince. Les extrémités supérieures des tiges 37a, 37b sont fixées sur une plaque 39 portant un cylindre de vérin 40a dont la tige 40b est fixée au bâti 34, de sorte que les manœuvres du vérin font coulisser les tiges 37a, 37b dans les douilles à billes et déplacent verticalement le support 38 et la pince 4.

La pince 4 est composée de deux mâchoires 4a, 4b articulées chacune autour d'un axe horizontal 41a, 41b. Les mâchoires comportent un prolongement qui pénètre dans une rainure d'une came 42 comportant deux rainures divergentes en forme de V. La came 42 est déplacée verticalement par un vérin 43 et le déplacement de la came provoque les ouvertures et fermetures des mâchoires 4a, 4b. Un second vérin 44, situé dans le prolongement de la tige du vérin 43, permet de régler la longueur de course de cette tige et donc de la came en Vé 42 et permet de régler les degrés d'ouverture successifs de la pince 42 suivant la largeur des plaquettes 5.

Les figures 1 et 2 représentent une pince coupante 45 qui est disposée au-dessous de la table 1c et qui a pour fonction de plier et de cisailler les bouts des pattes 6 qui dépassent au-dessous de la carte imprimée 3, lorsqu'une plaquette 5 a été insérée dans la carte.

La pince coupante 45 est déplaçable le long de l'axe vertical z z1 par un mécanisme identique au mécanisme de déplacement vertical de la pince 4. Ce mécanisme comporte un bâti fixe 46 qui est fixé à la table fixe 1a par un support en équerre 46a. Le bâti 46 est équipé de douilles à billes dans lesquelles coulissent des tiges verticales 47a, 47b portant à leur extrémité supérieure un support 48 de la pince. Les extrémités inférieures des tiges 47a, 47b sont fixées à une plaque 49 portant le cylindre 50a d'un vérin dont la tige 50b prend appui sur le bâti fixe 46, de sorte que les déplacements du vérin entraînent le déplacement vertical de la pince qui peut être reculée vers le bas pour permettre les déplacements de la table 10 puis ramenée contre la face inférieure de la carte 3.

La pince coupante 45 comporte deux mâchoires mobiles 45a, 45b articulées chacune autour d'un axe horizontal et un appui central fixe 51 qui est situé légèrement plus haut que les mâchoires mobiles et qui est appuyé contre la face inférieure de la carte 3. Les extrémités des deux rangées de pattes 6 d'une plaquette qui dépassent au-dessous de la carte 3 sont cisaillées entre l'appui central fixe 51 et les deux mâchoires mobiles. Les largeurs des mâchoires mobiles 45a, 45b et de l'appui fixe 51 selon l'axe y y1 sont égales à la longueur des plus grandes plaquettes, de sorte que toutes les pattes d'une plaquette sont cisaillées en une seule opération. La pince coupante 45 comporte un dispositif d'ouverture et de fermeture des mâchoires mobiles 45a, 45b identique à celui qui commande les pinces 4a et 4b.

Ce dispositif comporte une came 52 avec deux rainures en Vé, dans chacune desquelles pénètre un ergot solidaire d'une mâchoire et un vérin 53 qui déplace verticalement la came 52.

L'automate qui vient d'être décrit comporte n bras 15 et n − 1 rampes 9 et le but recherché est de diminuer la durée des cycles en combinant les opérations de telle sorte que plusieurs puissent être effectuées simultanément au cours d'une même étape.

Au cours d'une première étape de chaque cycle, un des bras 15, qui est disposé obliquement dans l'alignement d'une rampe 9, reçoit un circuit intégré. En même temps, la tête mobile portant la pince d'insertion 4 vient prendre une plaquette posée sur le bras 15a qui est en position horizontale. Au cours d'une deuxième étape de chaque cycle, la tête mobile portant la pince d'insertion descend verticalement en insérant la plaquette sur une carte et simultanément le distributeur rotatif central effectue un quart de tour pour repositionner les bras pour le prochain cycle.

Au début de la première étape, un moteur en courant continu entraînant un galet cranté en caoutchouc 10 équipant le magasin dans lequel se trouve la plaquette 5 à insérer libère celle-ci qui glisse le long de la rampe 9, traverse le dispositif inverseur de polarité 12 et s'engage sur le bras 15 placé en bout de la rampe. La butée 30 équipant ce bras positionne la plaquette 5 sur le bras. Un détecteur photo-électronique équipant chaque bras détecte la présence de la plaquette et autorise le passage à l'étape suivante.

Au cours de la deuxième étape de chaque cycle, le bras 15 qui a reçu la plaquette 5 est entraîné en rotation par l'arbre 20. Il est entraîné sur un nombre de fractions de tours tel qu'il vienne se placer dans l'alignement des axes v v1 et z z1. En même temps, le bras 15 est entraîné en pivotement autour de son axe 25 par l'effet de la came hélicoïdale 21a et du poussoir 23 et il vient occuper la position horizontale 15a. Durant le mouvement du bras 15, la pince 27 équipant le bras maintient la plaquette pour éviter qu'elle ne soit éjectée par la force centrifuge.

Un dispositif selon l'invention comporte un dispositif très efficace de positionnement et d'auto-centrage des cartes 3 par rapport à l'axe z z1 de la pince d'insertion.

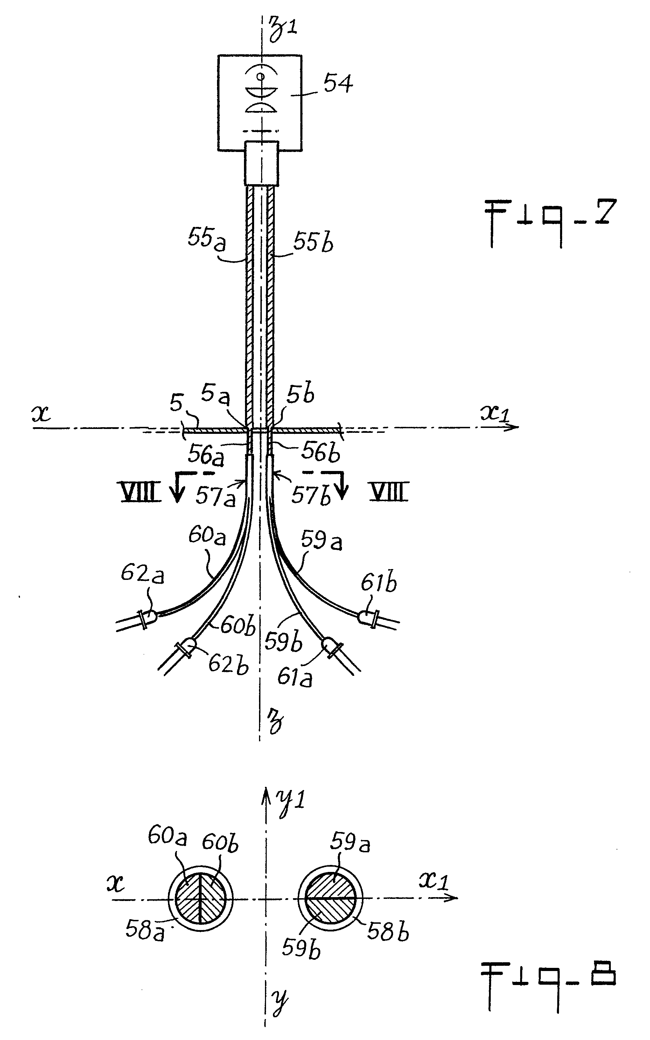

La figure 7 est une vue schématique de ce dispositif de positionnement. La figure 8 est une coupe selon VIII–VIII de la figure 1.

Le dispositif comporte un émetteur lumineux 54 qui est placé dans l'alignement de l'axe z z1, au-dessus du support mobile de la pince d'insertion, de sorte que lorsque la pince effectue son déplacement horizontal pour venir saisir la plaquette qui se trouve sur le bras 15a, deux faisceaux lumineux 55a et 55b, parallèles à l'axe z z1, sont projetés sur la carte 5 qui se trouve placée en position pour recevoir un circuit intégré.

La figure 7 représente une coupe par le même plan que la figure 1 sur laquelle on voit deux orifices 5a, 5b de la carte perforée qui sont placés dans un même plan transversal aux deux rangées de pattes 6 du circuit intégré et qui sont destinés à recevoir les deux premières pattes de chaque rangée.

L'émetteur 54 comporte une optique qui émet deux faisceaux lumineux 55a, 55b parallèles à l'axe z z1 et symétriques par rapport à celui-ci, dont l'écartement correspond à l'écartement normalisé des deux rangées de pattes 6. Les trous 5a, 5b ont par exemple un diamètre compris entre 0,7 et 1 mm selon les cartes et les deux faisceaux 55a, 55b projettent sur la face supérieure de la carte 5 deux taches circulaires ayant un diamètre supérieur à celui des trous, par exemple un diamètre de 2 mm. Les trous 5a, 5b laissent passer deux faisceaux lumineux 56a, 56b, alignés avec les trous, ayant le même diamètre que ceux-ci.

Au-dessous de la table mobile 1c portant la carte 5 se trouvent deux récepteurs photo-électriques 57a, 57b qui sont alignés par construction avec les faisceaux 55a et 55b.

Chaque récepteur comporte deux demi-fibres optiques conductrices de la lumière, qui sont enfermées dans une gaine cylindrique 58a, 58b ayant un diamètre de l'ordre de 1,6 mm. Les deux demi-fibres 59a, 59b d'un des récepteurs, par exemple celui de droite, sont symétriques par rapport à un plan diamétral parallèle aux axes z z1 et x x1. Les deux demi-fibres 60a, 60b de l'autre récepteur sont symétriques par rapport à un plan diamétral parallèle aux axes z z1 et y y1.

Chaque demi-fibre optique aboutit à un récepteur photo-électrique, par exemple à un phototransistor, respectivement 61a, 61b pour le récepteur de droite et 62a, 62b pour le récepteur de gauche.

Les signaux électriques issus des deux transistors de chaque récepteur sont comparés par un système différentiel, par exemple par un amplificateur différentiel et le signal d'écart commande automatiquement un servomoteur qui déplace la table correspondante 1b ou 1c dans le sens qui rétablit l'équilibre des éclairements. Le récepteur de droite agit sur la table 1b qui se déplace parallèlement à l'axe y y1 et le récepteur de gauche agit sur la table 1c qui se déplace parallèlement à l'axe x x1.

Le système d'auto-centrage qui vient d'être décrit est utilisé à deux stades différents. Il est utilisé une première fois en mode manuel pour créer et enregistrer un programme. Dans cette phase, les tables 1b et 1c portant une carte 3 sont déplacées en agissant manuellement sur des potentiomètres pour que les deux trous de référence 5a, 5b, destinés à recevoir une plaquette ou tout autre composant, viennent se positionner approximativement sous les taches lumineuses correspondant aux deux faisceaux 55a et 55b. Ensuite on met en route l'auto-centrage automatique et les servomécanismes affinent le positionnement. Lorsque le signal d'erreur est à zéro, on enregistre en mémoire les coordonnées x et y définissant la position à laquelle devra être amené le circuit imprimé pour recevoir le circuit intégré correspondant et ainsi de suite pour toutes les plaquettes de circuits intégrés et tous les composants à insérer sur une carte imprimée.

Dans la phase d'équipement automatique d'une carte, le programme positionne la carte selon les valeurs x et y enregistrées et le dispositif d'auto-centrage vérifie chaque fois que le positionnement est le bon et, s'il le faut, il corrige pour amener la carte dans la bonne position avant l'insertion du circuit intégré sur la carte.

Ce dispositif composé de deux récepteurs photo-électriques dont chacun est constitué par deux demi-fibres optiques s'est montré très précis. De plus, grâce à la flexibilité des fibres optiques, il est possible de le déplacer pour laisser passer la pince 45a, 45b destinée à plier et à sectionner les pattes des circuits intégrés.

On voit sur la figure 2 un bras 63 qui est articulé autour d'un axe 64 par rapport au support 46a. Lorsque la tête mobile portant les pinces 45 est déplacée vers le haut, une came écarte le bras articulé 63 pour laisser passer la pince coupante. Le bras 63 porte les récepteurs 57a, 67b qui suivent le mouvement du bras grâce à la flexibilité des fibres.

La figure 1 représente un dispositif 12 qui est intercalé entre les magasins 8 et l'extrémité inférieure de chaque rampe 9. Les plaquettes 5 de circuits imprimés présentent une polarité et elles sont rangées dans les étuis 7 toutes dans le même sens. Avant de les insérer sur les cartes de circuit imprimé, il est nécessaire de faire pivoter certaines plaquettes de 180° autour d'un axe perpendiculaire au plan de la plaquette, afin d'inverser la polarité. Le dispositif 12 permet d'obtenir cette inversion.

Le dispositif 12 comporte un disque 65 qui est monté pivotant autour d'un axe u u1. La face supérieure du disque 65 est située dans le prolongement de la rampe 9, de sorte qu'une plaquette qui glisse sur la rampe vient se positionner sur le disque 65. Le disque 65 est entraîné en rotation, pas à pas, par un groupe motoréducteur 66, qui effectue un tour complet chaque fois que l'unité logique le met en route et qui entraîne un dispositif indexeur 67 du même type que le dispositif indexeur à croix de Saint André 26 équipant et entraînant l'organe de transfert rotatif 13.

De plus, le dispositif 12 comporte une butée escamotable 68, qui permet de laisser passer librement une plaquette 5 s'il n'est pas nécessaire d'inverser la polarité ou de la bloquer sur le disque dans le cas contraire.

**Revendications**

1. Machine pour insérer automatiquement des plaquettes de composants électroniques, notamment des plaquettes de circuits intégrés (5), sur des cartes électroniques (3) de circuits imprimés, comportant en combinaison:
— une table horizontale (1b, 1c) déplaçable suivant deux axes perpendiculaires (xx1, yy1) sur laquelle lesdites cartes sont posées;
— un dispositif de transfert rotatif (13) qui est disposé au-dessus de ladite table et qui est entraîné en rotation, pas à pas, autour d'un axe de rotation vertical (v, v1), lequel dispositif de transfert comporte plusieurs bras radiaux (15a, 15b..15n) qui sont articulés chacun autour d'un axe horizontal (16a, 16b ... 16n);
— au moins une rampe (9, 9') inclinée en descendant vers un point situé sur ledit axe de rotation (v, v1);
— au moins une rangée de magasins verticaux (8) situés au-dessus de chaque rampe (9, 9') chaque magasin recevant un étui (7) dans lequel lesdites plaquettes sont livrées,
— et une pince (4) d'insertion desdites plaquettes qui est située au-dessus de ladite table (1c) et qui est portée par un support qui est déplaçable à la fois le long de son axe vertical (zz1) et horizontalement dans le plan (P) passant par ledit axe vertical (zz1) et par ledit axe de rotation vertical (v v1).

2. Machine selon la revendication 1, dans laquelle ledit dispositif de transfert rotatif (13) comporte des moyens pour maintenir lesdits bras radiaux (15b, 15c, 15d) inclinés parallèlement auxdites rampes (9) lorsqu'ils sont placés dans l'alignement de celles-ci et des moyens pour amener en position horizontale le bras (15a) qui se trouve dans ledit plan (P) passant par ledit axe de rotation vertical (v v1) du dispositif de transfert (13) et par ledit axe vertical (z z1) du support de la pince d'insertion.

3. Machine selon la revendication 2, dans laquelle ledit dispositif de transfert rotatif (13) comporte un groupe moto-réducteur (17) qui entraîne pas à pas un arbre de sortie (20), par pas égaux à l'écart angulaire entre deux bras radiaux, lequel arbre de sortie porte une pièce (14) sur laquelle lesdits bras radiaux (15) sont articulés et ledit dispositif comporte, en outre, une bague fixe (21) qui est coaxiale avec ledit arbre (20) et qui porte une came périphérique ayant la forme d'une rainure hélicoïdale (21a) et ledit dispositif comporte, en outre, n poussoirs (23a, 23b, 23c, 23d), parallèles audit arbre de sortie (20) et chacun desdits poussoirs est articulé par l'une de ses extrémités (25a, 25b, 25c, 25d) sur l'un desdits bras radiaux et porte un galet (24a, 24b, 24c, 24d) qui roule dans ladite rainure hélicoïdale (21a).

4. Machine selon l'une quelconque des revendications 1 à 3, dans laquelle chacun desdits bras radiaux (15) est équipé d'une pince (27) articulée autour d'un axe (28) et équipée d'un ressort de rappel (29) qui la maintient appuyée contre la plaquette (5) placée sur ledit bras lorsque ledit bras est entraîné en rotation.

5. Machine selon l'une quelconque des revendications 1 à 4, dans laquelle chacun desdits bras radiaux (15) comporte une butée (30) ayant la forme d'une fourche à deux bras contre les extrémités desquels viennent s'appuyer les deux premières pattes des deux rangées de pattes (6) de chaque plaquette (5) afin d'assurer un positionnement bien déterminé de celles-ci.

6. Machine selon l'une quelconque des revendications 1 à 5, dans laquelle ladite pince (4) d'insertion des composants est portée par un support comportant un premier vérin (40a) à axe vertical (z z1) et un deuxième vérin (35a) à axe horizontal situé dans le plan vertical passant par l'axe (v v1) dudit transfert rotatif et par l'axe (z z1) dudit premier vérin.

7. Machine selon l'une quelconque des revendications 1 à 6, comportant une pince (45) de pliage et de cisaillement de l'extrémité desdites pattes (6), laquelle pince est placée au-dessous de ladite table (1c) et comporte un vérin (50a) qui la déplace le long dudit axe vertical (z z1).

8. Machine selon l'une quelconque des revendications 1 à 7, comportant un dispositif photo-électrique d'auto-centrage des cartes (3) de circuit imprimé par rapport à l'axe (z z1) de la pince d'insertion (4), lequel dispositif comporte une émetteur lumineux 54 qui est situé au-dessus de ladite table mobile (1c) et qui émet deux faisceaux lumineux (55a, 55b) parallèles audit axe (z z1) et symétriques par rapport à celui-ci et il comporte, en outre, deux récepteurs photo-électriques (57a, 57b) qui sont situés au-dessous de ladite table, dans l'alignement desdits faisceaux, chacun de ces récepteurs étant composé de deux demi-fibres optiques symétriques par rapport à un plan diamétral et de deux photo-transistors (62a, 62b) situés en regard de l'extrémité de chacune desdites demi-fibres, lesquels photo-transistors sont placés dans un montage différentiel qui commande automatiquement le servomoteur qui déplace ladite table horizontale (1b, 1c) dans le sens qui annule la différence entre les deux signaux.

9. Machine selon la revendication 8, dans laquelle l'un desdits capteurs photo-électriques (57b) comporte deux demi-fibres optiques (59a, 59b), symétriques par rapport à un plan diamétral parallèle au plan passant par lesdits axes (x x1) et (z z1) et le signal différentiel émis par les deux photo-transistors (61a, 61b) correspondants commande le servomoteur qui déplace la table (1b) parallèlement à l'axe (y y1) et l'autre capteur photo-électrique (57a) comporte deux demi-fibres optiques (60a, 60b) symétriques par rapport à un plan diamétral parallèle au plan passant par lesdits axes (y y1 et z z1) et le signal différentiel émis par les deux photo-transistors (62a, 62b) correspondants commande le servomoteur qui déplace la table (1c) parallèlement à l'axe x x1.

10. Machine selon l'une quelconque des revendications 8 et 9, dans laquelle lesdites fibres optiques (59a, 59b, 60a, 60b) sont supportées par un bras (63) articulé autour d'un axe (64), lequel bras coopère avec une came portée par le support de ladite pince coupante (45), laquelle came écarte ledit bras articulé lorsque la pince coupante est déplacée vers le haut.

11. Machine selon l'une quelconque des revendications 1 à 10, dans laquelle chaque rampe (9) comporte un dispositif d'inversion de polarité (12) comportant un disque (65) dont la face supérieure est alignée avec ladite rampe, qui est entraîné en rotation pas à pas autour de son axe (u u1) par un groupe motoréducteur (66) et par un indexeur (67), et ledit dispositif comporte, en outre, une butée escamotable (68).

## Claims

1. Machine for automatically inserting electronic components boards, such as integrated circuit boards (5), on electronic cards (3) of printed circuits, comprising, in combination:
- a horizontal table (1b, 1c) which is movable along two perpendicular axes (xx1, yy1), and on which are placed the said cards;
- a rotary transfer device (13) which is placed above said table and which is driven in rotation, stepwise, about a vertical rotation axis (v, v1), which transfer device comprises a plurality of radial arms (15a, 15b,…15n), each one of which is mounted for pivoting about a horizontal axis (16a, 16b…16n);
- at least one ramp (9, 9') which is downwardly inclined towards a point situated on said rotation axis (v, v1);
- at least one row of stackers (8) situated above each ramp (9, 9'), each stacker receiving a case (7) in which said boards are supplied,
- and an inserting clamp (4) for said boards, which is situated above said table (1c) and which is borne by a support movable both along its vertical axis (zz1) and horizontally inside the plane (P) traversing said vertical axis (zz1) and said vertical rotation axis (vv1).

2. Machine according to claim 1, in which said rotary transfer device (13) comprises means for keeping said radial arms (15b, 15c, 15d) inclined in parallel to said ramps (9) when they are in alignment therewith, and means for bringing into a horizontal position the arm (15a) which is situated in said plane (P) traversing said vertical rotation axis (v v1) of the transfer device (13) and said vertical axis (z z1) of the insertion clamp support.

3. Machine according to claim 2, in which said rotary transfer device (13) comprises a geared motor (17) driving an output shaft (20) stepwise, each step being equal to the angular distance between two radial arms, said output shaft carrying a part (14) on which said radial arms are pivotally mounted, and said device further comprises a fixed ring (21) which is co-axial with said shaft (20) and which carries a peripheral cam shaped as a helical groove (21a), and said device further comprises n push-members (23a, 23b, 23c, 23d), which are parallel to said output shaft (20) and each one of which is mounted for pivoting by one of its ends (25a, 25b, 25c, 25d) on one of said radial arms and carries a roller (24a, 24b, 24c, 24d) rolling in said helical groove (21a).

4. Machine according to any one of claims 1 to 3, in which each of said radial arms (15) is equipped with a clamp (27) mounted for pivoting about an axis (28) and equipped with a return spring (29) which keeps it in resting contact against the board (5) placed on said arm when said arm is driven in rotation.

5. Machine according to any one of claims 1 to 4, in which each of said radial arms (15) comprises a stop (30) which is shaped as a fork with two arms against the ends of which come to rest the first two tabs of the two rows of tabs (6) of each board (5) in order to ensure a pre-determined positioning thereof.

6. Machine according to any one of claims 1 to 5, in which said components inserting clamp (4) is carried by a support comprising a first jack (40a) of vertical axis (z z1) and a second jack (35a) of horizontal axis situated inside the vertical plane traversing axis (v v1) of said rotary transfer and axis (z z1) of said first jack.

7. Machine according to any one of claims 1 to 6, comprising a clamp (45) for folding and shearing the end of said tabs (6), which clamp is placed under said table (1c) and comprises a jack (50a) which moves it along said vertical axis (z z1).

8. Machine according to any one of claims 1 to 7, comprising a photo-electrical device for the self-centering of the printed circuit boards (3) with respect to axis (z z1) of the inserting clamp (4), which device comprises a light emitter 54 situated above said movable table (1c) and emitting two light beams (55a, 55b) parallel to said axis (z z1) and symmetrical with respect to said axis, and further comprises two photo-electrical receivers (57a, 57b) situated under said table, in alignment with said beams, each of which receivers is composed of two halves of optical fibers which are symmetrical with respect to a diametrical plane, and of two photo-transistors (62a, 62b) situated in facing relationship to the end of each of said half of fiber, said photo-transistors being placed in a differential assembly controlling automatically the motor moving said horizontal table (1b, 1c) in the direction which cancels the difference between the two signals.

9. Machine according to claim 8, in which one of said photo-electrical receivers (57b) comprises two halves of optical fiber (59a, 59b), which are symmetrical with respect to a diametrical plane parallel to the plane traversing said axes (x x1) and (z z1) and the differential signal emitted by the two corresponding photo-transistors (61a, 61b), controls the servo-motor moving the table (1b) parallely to axis (y y1), and the other photo-electrical receiver (57a) comprises two halves of an optical fiber (60a, 60b) which are symmetrical with respect to a diametrical plane parallel to the plane traversing said axes (y y1 and z z1) and the differential signal emitted by the two corresponding photo-transistors (62a, 62b) controls the servo-motor moving the table (1c) in parallel to axis (x x1).

10. Machine according to any one of claims 8 and 9, in which said optical fibers (59a, 59b, 60a, 60b) are supported by an arm (63) mounted for pivoting about an axis (64), which arm cooperates with a cam carried by the support of said shearing clamp (45), said cam moving said pivotable arm aside when the shearing clamp is moved upwardly.

11. Machine according to any one of claims 1 to 10, in which each ramp 9 comprises a polarity reversing device (12) comprising a disc (65) the upper face of which is aligned with said ramp, which is driven in rotation stepwise about its axis (u u1) by a geared motor (66) and by indexing means (67), and said device further comprises a retractable stop (68).

**Patentansprüche**

1. Maschine zum automatischen Einlegen von Platten elektronischer Komponenten, insbesondere von Platten (5) integrierter Schaltkreise, auf elektronische Karten (3) von gedruckten Schaltungen, umfassend in Kombination:
– einen horizontalen Tisch (1b, 1c), auf dem die Karten liegen und der längs zweier zueinander senkrechter Achsen (x x1, y y1) verschiebbar ist;
– eine über dem Tisch angeordnete Rotationsübertragungs-Einrichtung (13), die schrittweise um eine vertikale Rotationsachse (v v1) in Rotation versetzt wird und mehrere radiale Arme (15a, 15b,...15n) umfasst, welche jeweils um eine horizontale Achse (16a, 16b,...16n) gelenkig befestigt sind;
– mindestens eine zu einem an der Rotationsachse (v v1) befindlichen Punkt abwärts geneigte Rampe (9, 9');
– mindestens eine Reihe von über jeder Rampe (9, 9') befindlichen vertikalen Magazinen (8), wobei jedes Magazin ein Gehäuse (7), in das die Platten übergeben werden, aufnimmt,
– und eine Einlegeklemme (4) für die Platten, die über dem Tisch (1c) angeordnet und von einem Träger getragen ist, welcher gleichzeitig entlang seiner vertikalen Achse (z z1) und horizontal in der durch die vertikale Achse (z z1) und die vertikale Rotationsachse (v v1) gehende Ebene (P) verschiebbar ist.

2. Maschine nach Anspruch 1, bei welcher die Rotations-Übertragungseinrichtung (13) Mittel zum Halten der radialen Arme (15b, 15c, 15d) parallel zu den Rampen (9) geneigt, wenn sie sich in einer Linie mit diesen befinden, und Mittel zum Bewegen des Armes (15a), der sich in der durch die vertikale Rotationsachse (v v1) der Übertragungseinrichtung (13) und die vertikale Achse (z z1) des Trägers für die Einlegeklemme gehenden Ebene (P) befindet, in eine horizontale Position umfasst.

3. Maschine nach Anspruch 2, bei welcher die Rotationsübertragungs-Einrichtung (13) eine Getriebemotorgruppe (17) umfasst, die eine Abtriebswelle (20) schrittweise antreibt, wobei die Schritte gleich dem Winkelabstand zwischen zwei radialen Armen sind, welche Abtriebswelle ein Stück (14) trägt, an welchem die radialen Arme (15) angelenkt sind, und die Einrichtung weiters einen fixen Ring (21) umfasst, der koaxial zur Welle (20) ist und eine periphere Nocke in Form einer Wellennut (21a) trägt, und die Einrichtung weiters n zur Abtriebswelle (20) parallele Stössel (23a, 23b, 23c, 23d) umfasst und jeder der Stössel mit einem seiner Enden (25a, 25b, 25c, 25d) an einem der radialen Arme angelenkt ist und eine Rolle (24a, 24b, 24c, 24d) trägt, die sich in der Wellennut (21a) dreht.

4. Maschine nach einem der Ansprüche 1 bis 3, bei welcher jeder der radialen Arme (15) mit einer um eine Achse (28) gelenkig befestigten Klemme (27) ausgestattet ist, welche mit einer Rückholfeder (29) versehen ist, die sie in Anlage an der auf dem Arm befindlichen Platte (5) hält, wenn der Arm in Rotation versetzt ist.

5. Maschine nach einem der Ansprüche 1 bis 4, bie welcher jeder der radialen Arme (15) einen Anschlag (30) in Form einer Gabel mit zwei Armen umfasst, gegen deren Enden die beiden ersten Füsse zweier Reihen von Füssen (6) jeder Platte (5) zur Sicherung einer bestimmten Position derselben zur Anlage gelangen.

6. Maschine nach einem der Ansprüche 1 bis 5, bei welcher die Klemme (4) zum Einlegen der Komponenten von einem Träger getragen ist, der einen ersten Stelltrieb (40a) mit vertikaler Achse (z z1) und einen zweiten Stelltrieb (35a) mit horizontaler Achse umfasst, die in der durch die Achse (v v1) des Rotationsübertragers und die Achse (z z1) des ersten Stelltriebs gehenden vertikalen Ebene liegt.

7. Maschine nach einem der Ansprüche 1 bis 6, umfassend eine Klemme (45) zum Umbiegen und Beschneiden des Endes der Klauen (6), welche Klemme unter dem Tisch (1c) angeordnet ist und einen Stelltrieb (50a) umfasst, der sie entlang der vertikalen Achse (z z1) verschiebt.

8. Maschine nach einem der Ansprüche 1 bis 7, umfassend eine fotoelektrische Einrichtung zum automatischen Zentrieren der Karten (3) der gedruckten Schaltung in bezug auf die Achse (z z1) der Einlegeklemme (4), welche Einrichtung einen über dem mobilen Tisch (1c) befindlichen Lichtgeber (54) umfasst, der zwei zur Achse (z z1) parallele und in bezug auf diese symmetrische Lichtbündel (55a, 55b) entsendet, und weiters zwei unterhalb des Tisches in einer Linie mit den Bündeln befindliche fotoelektrische Empfänger (57a, 57b) umfasst, wobei jeder dieser Empfänger aus zwei zu einer diametralen Ebene symmetrischen optischen Halbfasern und aus zwei gegenüber dem Ende jeder der Halbfasern befindlichen Fototransistoren (62a, 62b) zusammengesetzt ist, welche Fototransistoren in einer Differentialschaltung gelagert sind, die automatisch den Servomotor steuert, welcher den horizontalen Tisch (1b, 1c) in die Richtung verschiebt, die die Differenz zwischen den beiden Signalen aufhebt.

9. Maschine nach Anspruch 8, bei welcher einer der fotoelektrischen Aufnehmer (57b) zwei optische Halbfasern (59a, 59b) umfasst, die symmetrisch zu einer diametralen, zu der durch die Achsen (x x1) und (z z1) gehenden Ebene parallelen Ebene sind, und das von den zwei entsprechenden Fototransistoren (61a, 61b) entsendete Differentialsignal den Servomotor steuert, der den Tisch (1b) parallel zur Achse (y y1) verschiebt, und der andere fotoelektrische Aufnehmer (57a) zwei optische Halbfasern (60a, 60b) umfasst, die symmetrisch zu einer diametralen, zu der durch die Achsen (y y1) und (z z1) gehenden Ebene parallelen Ebene sind, und das von den beiden entsprechenden Fototransistoren (62a, 62b) entsendete Differentialsignal den Servomotor steuert, der den Tisch (1c) parallel zur Achse (x x1) verschiebt.

10. Maschine nach einem der Ansprüche 8 und 9, bei welcher die optischen Fasern (59a, 59b, 60a, 60b) von einem an einer Achse (64) gelenkig befestigten Arm (63) gehalten sind, welcher Arm mit einer vom Träger der Schneidklemme (45) getragenen Nocke zusammenwirkt, welche Nocke den Gelenkarm entfernt, wenn die Schneidklemme nach oben verschoben wird.

11. Maschine nach einem der Ansprüche 1 bis 10, bei welcher jede Rampe (9) eine Einrichtung zur Polaritätsumkehr (12) mit einer Scheibe (65) umfasst, deren Oberseite mit der Rampe fluchtet und die durch eine Getriebemotorgruppe (66) und einen Indexer (67) schrittweise in Rotation um ihre Achse (u u1) versetzt wird, und die Einrichtung weiters einen einklappbaren Anschlag (68) umfasst.

Fig.1

Fig.2

Fiq-3

Fiq-4

Fig_5

Fig_6

Fig. 7

Fig. 8